(19) Europäisches Patentamt
European Patent Office
Office européen des brevets

(11) **EP 2 343 728 A2**

(12) **EUROPÄISCHE PATENTANMELDUNG**

(43) Veröffentlichungstag:
**13.07.2011 Patentblatt 2011/28**

(51) Int Cl.:
*H01J 37/32* (2006.01)    *C23C 14/00* (2006.01)

(21) Anmeldenummer: **10015795.7**

(22) Anmeldetag: **17.12.2010**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(30) Priorität: **18.12.2009 DE 102009059097**

(71) Anmelder: **DTF Technology GmbH**
**01099 Dresden (DE)**

(72) Erfinder:
• **Liepack, Harald, dr.**
**01159 Dresden (DE)**
• **Gebel, Thoralf, Dr.**
**OT Langebrueck 01465 Dresden (DE)**
• **Krug, Mario**
**OT Berthelsdorf 01844 Neustadt i. Sa (DE)**
• **Galonska, Bernd**
**OT Weixdorf 01108 Dresden (DE)**

(54) **Verfahren und Vorrichtung zur Auswertung des von einem Plasma emilierten Lichtes zur Regelung von plasmagestützten Prozessen**

(57) Bei der Auswertung des von einem Plasma emitierten Lichtes in verschiedenen schmalbandigen Wellenlängenbereichen aus einem örtlichen Plasmabereich und eine damit gekoppelte schnelle Regelung von plasmagestützten Vakuumprozessen ergeben sich folgende Probleme:
- Verwendung eines sehr kostenintensiven akusto-optischen Spektrometers oder
- zu geringe Geschwindigkeit bei Verwendung eines normalen Spektrometers oder
- keine direkte örtliche Zuordnung sowie unterschiedliche Driften der Photomultiplier bei Verwendung von mehreren Kollimatoren, wobei jedem Kollimator jeweils ein separater optischer Filter und ein separater Photomultiplier zugeordnet ist.

Das neue Verfahren und die neue Vorrichtung soll eine kostengünstige und schnelle Auswertung des vom Plasma in verschiedenen schmalbandigen Wellenlängenbereichen aus einem örtlichen Plasmabereich emittierten Lichtes sowie eine damit gekoppelte kostengünstige und schnelle Regelung von plasmagestützten Vakuumprozessen ermöglichen.

Erfindungsgemäß wird die Aufgabe gelöst, indem das vom Plasma emittierte Licht mittels piezoelektrischen Faserschalter sequentiell auf verschiedene optische Filter und von diesen mittels eines weiteren piezoelektrischen Faserschalters synchronisiert und ebenfalls sequentiell auf denselben Photomultiplier geleitet wird. Die Auswertung der daraus entstehenden Signale nimmt ein μController vor, welcher anhand der Auswertergebnisse über integrierte PID-Regler die Regelung des Prozesses über die Steuerung von geeigneten Stellgliedern vornimmt.

Die Auswertung des vom Plasma emittierten Lichtes und die Regelung von plasmagestützten Vakuumprozessen.

Abbildung 3

EP 2 343 728 A2

**Beschreibung**

Die Erfindung betrifft eine Vorrichtung und ein Verfahren zur kostengünstigen und schnellen Erfassung und Auswertung des von einem Plasma in verschiedenen schmalbandigen Wellenlängenbereichen emittierten Lichtes sowie die Regelung von plasmagestützten Vakuumprozessen bei besonderer Minimierung von Driftprozessen bei denselben.

Stand der Technik

Es ist bekannt, das vom Plasma emittierte Licht zur Monitorierung und Regelung von Ätz-, Kammer-Clean- und Beschichtungsprozessen, insbesondere Magnetron-Sputter-Prozessen, zu benutzen (vgl. z.B. DD239810A1, US6818561B1, US6815362B1, US020040045934A1). So wird z.B. beim Magnetronsputtern das vom Plasma der Magnetronentladung emittierte Licht über einen Kollimator und eine Glasfaser aus dem Vakuum ausgekoppelt und auf eine Auswerteinheit geleitet. Diese Auswerteinheit kann entweder ein Spektrometer oder eine Kombination aus einem optisch schmalbandigen Filter und einem Photomultiplier (PM) sein. Außerdem ist in die Auswerteinheit in der Regel ein PID-Regler integriert, welcher als Ergebnis der Auswertungen ein analoges Spannungssignal an ein Stellglied weitergibt, welches dann auf den Prozess wirken kann. Es ist bekannt, dass sich durch die Targeterosion infolge des Magnetronsputterns Driften, insbesondere in der Beschichtungsrate ausbilden, da wegen der Verringerung der Targctdicke während des Sputterns (Targeterosion) sich der Abstand der zu sputternden Oberfläche zu den magnetfeldverursachenden Permanentmagneten verringert und dadurch eine Erhöhung der Magnetfeldstärke und demzufolge eine Änderung des Magnetronplasmas und somit auch der Beschichtungsrate einhergeht. Es ist bekannt, diese Drift insbesondere bei Planartargets durch ein verfahrbares Magnetfeld weitgehend zu kompensieren.
Es ist weiterhin bekannt, aus mehreren Messgrößen und deren mathematischen Verknüpfungen Regelgrößen für plasmabasierte Vakuumprozesse zu erzeugen (vgl. z.B. DE 10341513A1, DE 10208044B4, US 6603538B1, US 5877032A). Insbesondere ist bekannt, das vom Plasma bei bestimmten Wellenlänge emittierte Licht mittels akusto-optischen Spektrometer zu erfassen (vgl. DE10341513A1), Dort wird die Intensität von jeweils einer Spektrallinie des prozessbedingten Beschichtungsmaterials und des Reaktivgases bestimmt und ins Verhältnis gesetzt, um eine entsprechende Regelgröße zu erhalten. Zusätzlich können zur Genauigkeitsverbesserung die Messwerte für die Intensitäten in Abhängigkeit von der elektronischen Anregung korrigiert werden. Die elektronische Anregung wird bestimmt, indem das Verhältnis aus zwei Intensitäten von Spektrallinien eines dem Prozess zugesetzten und (beschichtungstechnisch) neutralen Gases (z.B. das beim Sputtern verwendeten Edelgases Argon) gebildet werden.
Zum Schutz eines optischen Sensors vor unbeabsichtigter Beschichtung ist aus DE102008017412A1 bekannt, einen optischen Sender bzw. Empfangen mit Gas zu beströmen.

Aus dem dargelegten Stand der Technik ergeben sich mehrere verschiedene Nachteile, die nachfolgend dargelegt werden.
Bei der Verwendung eines Spektrometers ergibt sich zwar die Möglichkeit, mehrere Wellenlängen bzw. Wellenlängenbereiche unter Nutzung von nur einem Kollimator, d.h. aus örtlich demselben Plasmabereich, zu monitorieren bzw. auszuwerten, wobei sich jedoch ein Spektrometer als sehr kostenintensiv und für viele Regelaufgaben als unzureichend bzgl. der Geschwindigkeit darstellt, was insbesondere für Produktionsprozesse nachteilig ist. Ausnahme hierfür stellt lediglich ein akusto-optisches Spektrometers dar, was im Vergleich mit normalen Spektrometern nochmals kostenintensiver ist. Für die Monitorierung einer Wellenlänge bzw. eines Wellenlängenbereiches stellt die Verwendung einer Kombination aus einem optisch schmalbandigen Filter und einem PM gegenüber einem Spektrometer eine sehr schnelle und relativ kostengünstige Grundlage für die Monitorierung bzw. Auswertung dar. Nachteilig ist jedoch, dass bei einer Monitorierung bzw. Auswertung von mehr als einer Wellenlänge bzw, einem Wellenlängenbereich für jede Wellenlänge bzw. jeden Wellenlängenbereich je ein Kollimator, eine Glasfaser, ein optisches Filter und ein PM benötigt werden. Damit wird der Kostenvorteil gegenüber der Verwendung eines Spektrometers relativiert. Weiterhin stammt das bei Verwendung von mehreren Kollimatoren erfasste Licht nicht exakt aus demselben örtlichen Plasmabereich. Zusätzlich wirkt sich bei der Verwendung von mehreren PM die unterschiedliche Drift derselben insbesondere bei längeren Prozessdauern negativ auf die Prozessstabilität aus (Prozessdriften). Insbesondere im Produktionsbetrieb, z.B. dem Magnetronsputtern, werden jedoch längere und vor allen Dingen ununterbrochene Prozcsszciten in der Größenordnung der Targetlebensdauer gefordert, was bei ausreichend dimensionierten Planar- oder Rohrtargets durchaus ununterbrochene Prozesszeiten von mehr als 150 Stunden bedeuten.
Neben den Driften der PM können Driften, welche z.B. beim Magnetronsputtern durch Targeterosion entstehen, nur teilweise kompensiert werden. Zwar kann das Magnetfeld der Sputterquellen verfahrbar gestaltet werden, um der Verringerung der Targetdicke im Zentrum des Erosionsgrabens entgegenzuwirken, aber zusätzliche Driften, die entstehen, weil sich die Topographie des Targets infolge der Targeterosion ändert, können durch diese Maßnahme nicht kompensiert werden.

Nachteilig an dem in DE10341513A1 geschilderten Verfahren bzw. an der Anordnung ist jedoch die Verwendung des sehr kostenintensiven akusto-optischen Spektrometers. Weiterhin wird in nachteiliger Weise davon ausgegangen, dass eine Verschmutzung des Sensors, welcher für die Erfassung des vom Plasma emittierten Lichtes verantwortlich ist, mit Betichichtungsmaterial keine Auswirkungen auf den Prozess hat. Ablagerungen von Beschichtungsmaterial wirken in der Regel jedoch nicht als Graufilter, welcher idealer Weise alle Wellenlängen des transmitticrenden Lichtes gleichmäßig schwächen würde, sondern als wellenlängenabhängiger Filter. So absorbiert ZnO (Zinkoxid), welches bei reaktivem Sputtern von Zn (Zink) und $O_2$ (Sauerstoff) abgeschieden wird, bekanntlich Licht mit einer Wellenlänge von weniger als 400 nm sehr stark und wird deswegen als UV-Absorber eingesetzt. Eine ZnO-Beschichtung auf einem Sensor, welcher für die Erfassung des vom Plasma emittierten Lichtes verantwortlich ist, erschwert jedoch die Beobachtung bzw. Monitorierung von angeregten Zn-Atomen unterhalb von 400 nm (z.B. bei 307 nm; 328 nm; 330 nm und 334 nm; vgl. http://physics.nist.gov/PhysRefData/ASD/index.html) bzw. macht eine Auswertung unterhalb von 400 nm Wellenlänge praktisch unmöglich.

Aufgabenstellung

Aufgabe der Erfindung ist es daher, ein Verfahren und eine Vorrichtung bzw. Anordnung zu schaffen, welche zur kostengünstigen und schnellen Auswertung des von einem Plasma in verschiedenen schmalbandigen Wellenlängenbereichen emittierten Lichtes sowie zur kostengünstigeil und schnellen Regelung von plasmagestützten Vakuumprozessen bei besonderer Minimierung von Driftprozessen dienen.

Diese Aufgabe wird erfindungsgemäß gelöst, indem verfahrenstechnisch zunächst die Intensitäten von an dem Prozess direkt bzw. indirekt beteiligten Materialien in geeigneten schmalbandigen Wellenlängenbereichen erfasst wird. Ein für ein Material geeigneter Schmalbandiger Wellenlängenbereich ist ein Wellenlängenbereich, in welchem sich mindestens eine charakteristische optische Emissionslinie für dieses Material befindet und weiterhin die Intensität dieser Emissionslinie nur vernachlässigbar von Emissionslinien anderer am Prozess betciligeter Materialien beeinflusst wird. In der Regel ist ein solcher schmalbandiger Wellenlängenbereich nicht breiter als wenige nm. Ein solcher Wellenlängenbereich kann sehr gut z.B. mit dielektrischen Interferenzfiltern gefiltert werden, welche eine Halbwertsbreite von typischer Weise weniger als 10 nm bei hoher Kantensteilheit besitzen.

Direkt und indirekt am Prozess beteiligte Materialien können z.B. das Trägergas (z.B. Argon beim Magnetronsputtern), Beschichtungsmaterialien, Precursoren, Radikale und Reaktivgase sein. Die verschiedenen schmalbandigen Wellenlängenbereiche werden so gewählt, dass keine Überschneidungen derselben auftreten. Die erfassten Intensitäten werden in mathematische Beziehungen gesetzt, insbesondere der Quotientenbildung. Dabei wird in überraschender Weise gefunden, dass sich zur Regelung von plasmagestützten Prozessen insbesondere die folgenden Größen hervorragend und mit ausreichender Genauigkeit eignen:

$$G_k^{ij} = \frac{P_{ij}}{T_k} \qquad \text{mit } j \neq k \text{ und } T_k > 0$$

$$K_{mn}^{ij} = \frac{P_{ij}}{P_{mn}} \qquad \text{mit } j \neq n \text{ und } P_{mn} > 0$$

Hierbei sind :

$T_k$ ... optische Intensität des Trägergases (z.B. Argon beim Sputtern) im schmalbandigen Wellenlängenbereich k

$P_{ij}$ ... optische Intensität der Prozesskomponente i im schmalbandigen Wellenlängenbereich k

$P_{mn}$ ... optische Intensität der Prozesskomponente m im schmalbandigen Wellenlängenbereich n.

Hierbei stellt der Quotient $\frac{P_{ij}}{T_k} = G_k^{ij}$ den auf die elektronische Anregung des Trägergases im schmalbandigen Wellenlängenbereich k normierten Anteil der i-ten Prozesskomponente im schmalbandigen Wellenlängenbereich j dar und ist ein relatives Maß für die Plasmadichte bzw. für den jeweiligen konkreten Prozess ein relatives Maß für die in das Plasma eingekoppelte elektrische Leistung. Deswegen kann $G_k^{ij}$ zur Überwachung des Plasmaprozesses bzw. über eine Regelung zur Eliminierung von Driften eingesetzt werden, welche z.B. durch Temperatureffekte bzw. durch Targeterosion (beim Magnetronsputtern) oder Füllsrandsänderungen vom Verdampfertiegel (bei Verdampfungsprozessen) entstehen können. Bei einer Änderung von $G_k^{ij}$ kann über einen oder mehrere PID-Regler auf die Drift dermaßen reagiert werden, dass entweder die in das Plasma einkoppelnde Leistung nachgeführt und/oder die Zufuhrrate der Prozesskom-ponenten in den Prozessraum entsprechend angepasst werden (z.B. die Anpassung von Gasflüssen, die Änderung der Heizleistung bei Verdampfern, ...). Der Quotient $\frac{P_{ij}}{P_{mn}} = K_{mn}^{ij}$ stellt den auf die Intensität der m-len Prozesskomponente im schmalbandigen Wellenlängenbereich n normierten Anteil der i-ten Prozesskomponente im schmalbandigen Wellenlängenbereich j dar.

Da die Lichtemission der einzelnen Prozesskomponenten in den bestimmten schmalbandigen Wellenlängenbereichen ein relatives Maß für die Konzentration dieser Prozesskomponenten im Prozessraum sind, kann $K_{mn}^{ij}$ dazu benutzt werden, um über einen oder mehrere PID-Regler die Anteile der einzelnen Prozesskamponenten konstant zueinander zu halten. Beispiele hierfür sind die Regelung der Sputterleistungen der einzelnen Sputterquellen beim Co-Sputtern, die Regelung der zu den Verdampfern zugeführten Leistungen bei der Co-Verdampfung von mehreren Materialien, die Regelung der Einlassmengen der Precursoren bei der PECVD sowie die - im Vergleich zur konventionellen Regelung beim reaktiven Magnetronsptittern - wesentlich genauere Regelung des Reaktivgasflusses beim Magnetronsputtern.

Die Aufgabe wird weiterhin erfindungsgemäß mit einer Vorrichtung bzw. einer Anordnung gelöst, indem das vom Plasma emittierte und in den Kollimator eintretende, zunächst noch nicht optisch gefilterte, Licht, welches gegebenenfalls über ein optisch fokussierendes Element, z.B. eine Sammellinse, auf eine oder ein Bündel von Glasfasern gelenkt wird. Die Glasfaser bzw. das Bündel von Glasfasern leitet dieses Licht an die außerhalb des Vakuumrezipienten befindliche Auswerteinheit. In dieser Auswerteinheit befinden sich die Elemente von mindestens einem Eingangskanalumschalter, einem Filterblock, einem Ausgangskanalumschalter, einem PM und einem $\mu$ Controller mit mindestens einem integrierten PID-Regler. Hierbei schaltet der Eingangskanalumschalter, welcher z.B. ein optischer Multiplexer bzw. ein piezoelektrischer Faserschalter sein kann, das noch ungefilterte Licht, welches Über die Glasfaser bzw. das Bündel von Glasfasern bis zum Eingang der Auswerteinheit geleitet wurde, auf ein Filterelement des Filterblocks. Der Filterblock besteht aus mehreren optischen Filterelementen. Jedes Filterelement, z.B. ein dielektrischer Interferenzfilter, stellt dabei ein schmalbandiges Wellenlängenfilter für einen bestimmten Wellenlängenbereich dar. Der Ausgangskanalumschalter, z.B. ein weiterer optischer Multiplexer, schaltet simultan mit dem Eingangskanalumschalter. Somit wird sichergestellt, dass von dem in das Filterelement eintretende noch ungefilterte Licht, nur Licht eines bestimmten schmalbandigen Wellenlängenbereiches den Ausgangskanalumschalter erreicht. Der Ausgangskanalumschalter stellt sicher, dass das durch das Filterelement transmittierende Licht auf den PM trifft. Der PM wandelt das an seinem Eingang einfallende Licht in eine entsprechende elektrische Spannung, die der in dem speziellen schmalbandigen Wellenlängenbereich entsprechend erfassten Intensität entspricht, um. Diese elektrische Spannung wird über den Ausgang des PM einem Eingang des $\mu$Controllers zugeführt. Der $\mu$Controller seinerseits ist so ausgeführt, dass durch dessen Steuerung des oder der Eingangskanalumschalter und des Ausgangskanalumschalters während eines bestimmten Zeitabschnittes das vom Plasma emittierte Licht durch ein bestimmtes Filterelement zum PM geleitet wird.

Somit wird über das sequentielle Durchschalten aller im Filterblock enthaltenen Filterelemente pro Eingangskanal des $\mu$Controllers die Intensität des Lichtes in den durch diese Filterelemente bestimmten schmalbandigen Wellenlängenbereichen sequentiell durch den $\mu$Controller erfasst. Die Steuerung von einem oder mehreren Eingangskanalumschaltern sowie einem Ausgangskanalumschalter erfolgt über den $\mu$Controller, indem über Digitalausgänge des $\mu$Controllers an die Digitaleingänge der Ein- bzw. Ausgangskanalumschalter entsprechende zeitlich gesteuerte Signale angelegt werden, die festlegen, wie die Ein- bzw. Ausgangskanalumschalter zu schalten sind. Da nicht jedes Filterelement des Filterblocks das gleiche Transmissionsvermögen besitzt bzw, die Übertragungselemente, wie z.B. die Glasfaser bzw. das Bündel von Glasfasern, in unterschiedlichen Wellenlängenbereichen unterschiedliche Transmissionseigenschaften besitzen und die Lichtintensität des vom Plasma in den unterschiedlichen Wellenlängenbereichen emittierten Lichtes sehr unterschiedlich sein kann, muss der Vertärkungsfaktor, der durch eine konstante elektrische Spannung an einen entsprechenden Eingang des PM vorgegeben werden muss, für die Erfassung der Lichtintensität in den entsprechenden schmalbandigen Wellenlängenbereichen, einzeln vorgegeben werden. Zu diesem Zweck verfügt der $\mu$Controller über entsprechende Analogausgänge, die eine in einen bestimmten Zeitbereich konstante Spannung, welche mit der Messfrequenz $f_M$ umgeschaltet werden kann, ausgeben können. Die Größe der Verstärkungsfaktoren bzw. die Höhe der dazu korrespondierenden Verstärkungsspannungen werden in einer separaten Kalibrierphase zu Beginn des Prozesses festgelegt. Die Kalibrierphase ihrerseits ist dabei stark prozessabhängig. Beispiele für eine Kalibrierphase werden in den Ausführungsbeispielen gegeben. Das Umschalten auf den entsprechenden Verstärkungsfaktor erfolgt simultan mit dem Schalten der Ein- bzw. Ausgangskanalumschalter. Die vom $\mu$Controller sequentiell erfassten Intensitätsäquivalente werden im $\mu$Controller zwischengespeichert, bis alle für die Auswertung erforderlichen Intensitätsäquivalente erfasst sind. Anschließend führt der $\mu$Controller die mathematischen Verknüpfungen, insbesondere die Quotientenbildung, aus. Der in der erfindungsgemäßen Vorrichtung bzw. Anordnung verwendete $\mu$Controller verfügt über mindestens einen integrierten PID-Regler. Die Soll-Werte für den PID-Regler werden über die (serielle) UART-Schnittstelle des $\mu$Controllers von einer externen Eingabeeinheit (z.B. PC, übergeordnete Anlagensteuerung, separates Touchpannel) vorgegeben und im $\mu$Controller gespeichert. Die über die mathematischen Verknüpfungen, insbesondere der Quotientenbildung, erhaltenen Ergebnisse werden mit den über die UART-Schnittstelle vorgegebenen und im $\mu$Controller gespeicherten Soll-Werten verglichen, indem eine entsprechende Differenz gebildet wird. Diese bildet für den PID-Regler die Regeldifferenz. Der PID-Regler gibt dann an mindestens einem der vom µController zugeordneten Analogausgängen ein 0 V bis 10 V-Spannungssignal als Steuergröße an das Stellglied (z.B. Steuereingang einer Stromversorgung, eines MFCs, eines Regelventils....). Handelt es sich bei dem Stellglied um ein Stellglied, welches an seinem Steuereingang für die Steuergrößen einen anderen Spannungsbereich als 0 V bis 10 V bzw. anstelle der Spannung als Steuergröße ein entsprechenden elektrischen Strom oder anderes Signal benötigt, so wird zwischen dem Analogausgang des µControllers und dem Eingang des Stellgliedes ein Wandlerbaustein eingesetzt. Das Stellglied seinerseits wirkt dann in gewünschter Weise regelnd auf den Plasmaprozess ein. Die maximale Messfrequenz $f_M$ mit

$$f_M = \frac{1}{(t_M + t_{Schalt})}$$ wird dabei durch die Faktoren der Schaltzeit der Ein- bzw. Ausgangskanalumschalter $t_{Schalt}$ sowie durch die erforderliche Messzeit $t_M$ des PM bestimmt und liegt typischerweise bei einigen hundert Hz. Bei der Kaskadierung des oder der Eingangskanalumschalter, welche mit der Frequenz $f_M$ arbeiten, mit einem weiteren vorgeschalteten Eingangskanalumschalter, wird der vorgeschaltete Eingangskanalumschalter mit der Frequenz $f_M^{\bullet}$ angesteuert. Das Schalten des vorgeschalteten Eingangskanalumschalters mit der Frequenz $f_M^{\bullet}$ erfolgt dabei synchron mit einer Schaltflanke der Signalfrequenz $f_M$. $f_M^{\bullet}$ ergibt sich dabei

aus $f_M^{\bullet} = \frac{f_M}{z}$, wobei z die Anzahl der in der Filterbox integrierten Filterelemente bzw. bei mehreren Filterboxen die maximale Anzahl der in einer Filterbox enthaltenen Filterelemente darstellt. Die Messfrequenz ist für die bisher bekannten Plasmaprozesse, wie z.B. dem metallischen Sputtern, dem reaktiven Sputtern, HPPMS bzw. HiPIMS - wo eine zeitliche Synchronisation erfolgt, PECVD sowie plasmachemische Ätz- und Reinigungsprozesse mehr als ausreichend.

Ausführungsbeispiele

Das erfindungsgemäße Verfahren bzw. die erfindungsgemäße Vorrichtung bzw. Anordnung wird nachfolgend anhand von 3 Ausführungsbeispielen näher erläutert.

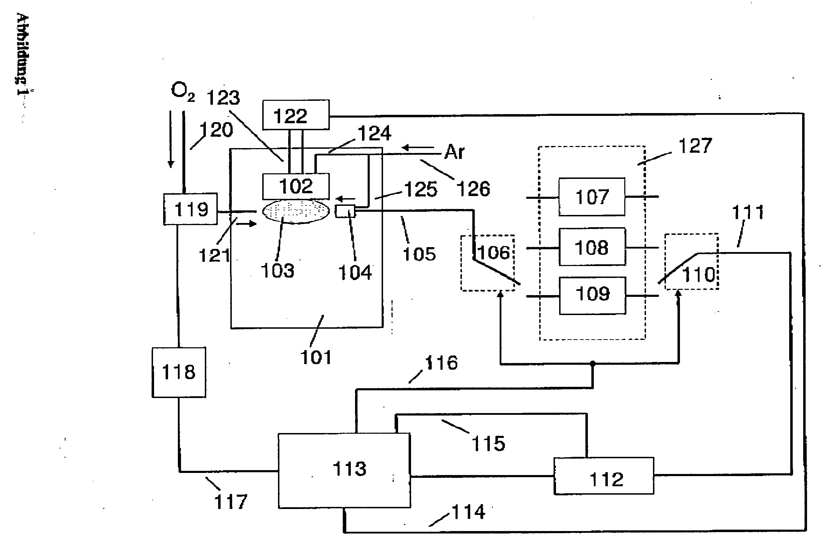

In Abb.1 ist die schematische Anordnung für eine Reaktivgasregelung beim voll reaktiven Magnetronsputtern von $TiO_2$ bei besonderer Minimierung von Driften für das erfindungsgemäße Verfahren bzw. die entsprechende Vorrichtung dargestellt.
In der Prozesskammer (101), welche als Vakuumkammer mit einem entsprechenden Pumpensystem ausgeführt ist, befindet sich eine Magnetron-Sputterquelle

(102), welche mit einem Sputtertarget aus Titan und zur groben Kompensation der Beschichtungsratedrift mit einem verfahrbaren Magnetfeldsystem ausgerüstet ist. Durch die Zufuhr eines Trägergases (124,125), in diesem Fall Argon, über die Sputterquelle (102) sowie durch den optischen Kollimator (104) wird in der Prozesskammer (101) durch Steuerung des dort integrierten Vakuumsystems ein Druck erzeugt, der es ermöglicht, mit Hilfe einer Stromversorgung (122) und deren entsprechenden Zuleitungen (123) zur Sputterquelle (102) ein Plasma (103) zu generieren, welches durch den Zerstäubungsprozess, dem Sputtern, verschiedene Spezies, wie neutrale, angeregte und ionisierte Argon-Atome bzw. neutrale, angeregte und ionisierte Titan-Atome sowie bei Zugabe von Reaktivgas, in diesem Fall Sauerstoff, auch dessen neutrale, angeregte und ionisierte Atome bzw. Moleküle, enthält. Über den Argon-gespülten Kollimator (104) wird mittels eines Lichtwellenleiters (105), welcher aus einer Glasfaser oder einem Bündel von Glasfasern bestehen kann, das, von den im Plasma (103) befindlichen Spezies, emittierte Licht an den Eingang des Eingangskanalumschalters (106), in diesem Fall einen piezoelektrischen Faserschalter 1:3, geleitet. Der µController (113) sendet über Steuerleitungen (116) BCD-Binärcode und schaltet dadurch den Eingangskanalumschalter (106) und den Ausgangskanalumschalter (110), in diesem Fall ein piezoelektrischer Faserschalter 3:1, simultan so, dass stets ein Eingang des Filterblocks (127) mit dem Eingangskanalumschalter (106) und das der entsprechende Ausgang des Filterblocks (127) mit dem Ausgangskanalumschalter (110) verbunden ist. Je nach Schalterstellung muss das Licht im Filterblock (127) den dielektrischen Interferenzfilter für Titan (107), Sauerstoff (108) oder Argon (109) passieren. Dabei wird nur Licht in dem für den Filter durchlässigen schmalbandigen Wellenlängenbereich hindurchgelassen. Der Ausgangskanalumschalter (110) leitet über den Lichtwellenleiter (111), welcher aus einer Glasfaser oder einem Bündel von Glasfasern bestehen kann, das von der Filterbox (127) vermittels der verschiedenen Filterelemente (107,108 oder 109) gefilterte Licht auf den Eingang des PM (112). Der PM (112) wandelt das eintreffende Licht in eine elektrische Spannung, welche am Ausgang des PM (112) zur Verfügung gestellt wird. Die Höhe der am Ausgang des PM (112) bereitgestellten Spannung wird neben der am Eingang des PM (112) eintreffenden Lichteintensität vom Verstärkungsfaktor, genauer gesagt der am Steuereingang des PM (112) anliegenden Verstärkerspannung, bestimmt. Diese Verstärkerspannung wird als Referenzspannung vom µController (113) über einen entsprechenden Ausgang am µController (113), mittels einer Steuerleitung (115), dem PM (112) über einen entsprechenden Eingang zugeführt. Die Höhe dieser Referenzspannung wird vom µController (113) simultan mit dem Schalten des Eingangskanalumschalters (106) und den Ausgangskanalumschalter (110) in Abhängigkeit von der Position der Umschalter (106,110) vorgegeben. Im anfänglichen Betrieb der Magnetron-Sputterquelle

(102) wird nach dem Zünden des Plasmas (103) ohne Betrieb mit Reaktivgas (in diesem Fall Sauerstoff) für kurze Zeit (typischer Weise 3 min bis 5 min) rein metallisch gesputtert, um das Target zu konditionieren, d.h. Verunreinigungen der Targetoberfläche zu entfernen. Nach der Konditionierung der Targetoberfläche der Sputterquelle (102) werden in der sogenannten Kalibrierphase des Prozesses die Verstärkungsspannungen, welche durch den μController (113) auf den Steuereingang des PM (112) im späteren reaktiven Prozess gegeben werden, bestimmt. Dazu werden beim rein metallischen Sputtern in der Kalibrierphase die optische Intensität in dem speziellen schmalbandigen Wellenlängenbereich für Titan über das Filterelement (107) und für Argon über das Filterelement (109) bestimmt, wobei die anfängliche Verstärkungsspannung für Titan und Argon beliebig sein kann. Zur Bestimmung dieser Intensitäten schaltet der μController (113) über Steuerleitungen (116) durch BCD-Binärsignale den Eingangskanalumschalter (106) und den Ausgangskanalumschalter (110) so, dass das vom Kollimator (104) über den Lichtwellenleiter (105) geleitete Licht während einer Messzeit $t_M$ durch das Filterelement für Titan (107) gefiltert und über den Lichtwellenleiter (111) auf den Eingang des PM (112) gelegt wird. Beim Schalten des Eingangskanalumschalters (106) und des Ausgangskanalumschalters (110) wird simultan die (noch beliebige) Verstärkerspannung für den PM (112) durch den μController (113) über die entsprechenden Steuerleitungen (115) am entsprechenden Eingang des PM (112) gelegt. Die vom PM (112) in eine entsprechende Spannung gewandelte LichtIntensität wird als analoge Spannung am Ausgang des PM (112) zur Verfugung gestellt. Der damit verbundene Eingang des μControllers (113) wandelt dieses Spannungssignal mittels integrierter A/D-Wandler und speichert das entstehende Ergebnis in einem ebenfalls integrierten Speicher zwischen. Anschließend wird der optische Signalweg auf Argon umgeschaltet, d.h. der μController (113) schaltet über die Steuerleitung (115) den Verstärkungsfaktor und über die Steuerleitungen (116) den Eingangskanalumschalter (106) und Ausgangskanalumschalter (110) auf das Filterelement für Argon (109) und wiederholt die Prozedur der Intensitätserfasung durch den μController (113) für Argon. Die während einer Gesamtzeit von etwa 20 ms bis 30 ms einzeln gespeicherten Intensitätsaquivalentwerte werden dann jeweils für Argon bzw. Titan gemittelt. Die Werte für die Verstärkerspannungen werden durch den μController (113) nun so angepasst, dass die während des nächsten Messzyklus von Argon bzw. Titan vom PM (112) generierten Spannungen für Argon in etwa 5 V bzw. 9,5 V für Titan ergeben. Dieser Kalibrierprozess wird für eine Dauer von typischer Weise einigen Sekunden iterativ wiederholt, bis die Änderung der in jedem Zyklus bestimmten Verstärkerspannungen zueinander weniger als 0,5 % beitragen. Bei Erfüllung dieser Bedingung werden die Verstärkungsspannungen von Argon bzw. Titan nachfolgend nicht mehr geändert.

Nach Abschluss der Kalibrierphase schließt sich die Phase der Sauerstoffkalibrierung an.

Die Sauerstoffkalibrierung erfolgt, indem auf die Ausgangsleitung (117) des μControllers (113) eine Spannung ausgegeben wird, welche im Bereich von 0V bis 10 V liegt. Diese Spannung wird über einen DC-DC-Wandler (118) auf einen Spannungsbereich von 0 V bis 150 V gewandelt und auf ein piezoelektrisches Regelventil (119) als Steuerspannung gegeben. Das piezoelektrische Regelventil (119) dosiert den von der zentralen Sauerstoff-Versorgung der Anlage kommenden Sauerstoff (120) so, dass der Anteil der über das Sauerstorfeinlassystem (121) injizierte Sauerstoff abhängig von der am Eingang des piezoelektrischen Regelventils (119) angelegten elektrischen Steuerspannung ist. Beim Einlassen von Sauerstoff in den Prozess sinkt die im speziellen schmalbandigen Wellenlängenbereich für Titan ermittelte Lichtintensität. Der im μController (113) enthaltene PID-Regler regelt die in den Prozess eingelassene Sauerstoffmenge über die Änderung der an die Ausgangsleitung (117) angelegten Steuerspannung des piezoelektrischen Regelventils (119) so, dass eine bestimmte, aus der Erfahrung stammende, Lichtintensitätsabsenkung erreicht wird. Die aus der Erfahrung stammende Lichtintensitätsabsenkung, welche für den gewünschten Prozess notwendig ist, wird vor dem Prozessstart mittels externen Eingabemöglichkeiten (z.B. Touchpad oder externe Anlagenstcucrung) über die im μController (113) integrierte UART-Schnitestelle eingegeben. Nach Stabilisierung der Sauerstofregelung, was typischerweise ca. 30 s bis 60 s dauert, wird die Lichtintensität in dem speziellen schmalbandigen Wellenlängenbereich für Sauerstoff mit Hilfe der Umschaltung des optischen Signalweges, d.h. der Lichtfilterung über das Filterelement (108), mit der Frequenz $f_M$ bestimmt. Die einzelnen bestimmten Lichtintensitäten werden gespeichert. Nach ca. 20 ms bis 30 ms wird jeweils ein Mittelwert gebildet. Die Verstärkungsspannung, welche vom μController (113) auf den Eingang des PM (112) über die Steuerleitung (115) gegeben wird, wird in diesem Fall so eingestellt, dass der vom μController (113) gebildete Mittelwert für die Lichtintensität eine vom PM (112) generierten Spannung von etwa 5 V ergibt. Dieser Sauerstoffhalibrierprozess wird iterativ wiederholt, bis die Änderungen der in jedem Zyklus bestimmten Verstärkungsspannungen zueinander weniger als 0,5 % betragen. Bei Erreichen dieser Bedingung wird die Verstärkungsspannung für Sauerstoff nicht mehr geändert. Nach Beendigung des Sauerstoffkalibrierprozesses wird die Regelung des Prozesses in den Regelmodus für ein stabiles Betriebsregime geschaltet.

In dem Regelmodus des stabilen Betriebsregimes wird der optische Signalweg durch den μController (113) mit der Frequenz $f_M$ so umgeschaltet, dass über die Filterelemente (107,108, 109) die Intensitäten von Titan, Sauerstoff und Argon bestimmt und deren Werte im μController (113) gespeichert werden. Alle 20 ms bis 30 ms werden von den ermittelten Intensitäten die entsprechenden Mittelwerte gebildet, welche dann vom μController **(113)** mathematisch verknüpft werden. Bei der hier vorgestellten Regelung handelt es sich um eine Quotientenbildung, d.h. es werden die Größen $G_k^{ij}$ bzw. $K_{mn}^{ij}$ gebildet, wobei $G_k^{ij}$ aus den entsprechenden Intensitäten von Titan und Argon bzw. $K_{mn}^{ij}$ aus den entsprechenden Intensitäten von Sauerstoff und Titan gebildet werden. Vorteilhafterweise wird der Wert $K_{mn}^{ij}$ so gebildet, dass der Mittelwert für die Intensität von Titan Divisor und der von Sauerstoff Dividend beim Quotienten ist. Der μController **(113)** regelt den Prozess nun so, dass sowohl $G_k^{ij}$ als auch $K_{mn}^{ij}$ konstant gehalten werden. Der zeitliche Rahmen, in welchen für $G_k^{ij}$ bzw. $K_{mn}^{ij}$ eine Regelung notwendig wird, unterscheidet sich stark. Während in **Abb. 1** $G_k^{ij}$ Ausdruck für die Langzeitstabililät der Zerstäubungsrate für das Titan ist und damit im Wesentlichen langsamen Driftprozessen unterworfen ist, ist $K_{mn}^{ij}$ Ausdruck des Verhältnisses zwischen dem Reaktivgas (Sauerstoff) und dem Titan, welches prozcssbedingt im Subsekundenbereich schwanken kann. Dieser Fakt wird vom μController **(113)** berücksichtigt, als das der μController **(113)** die über seine Ausgangsleitung **(117)** bereitgestellte Steuerspannung alle 20 ms bis 30 ms gemäß der erfolgten Auswertung aktualisiert. Für die Konstanthaltung des Faktors $G_k^{ij}$ ändert der μController **(113)** die an einer analogen Ausgangsleistung **(114)**, welche mit dem Steuereingang der Stromversorgung **(122)** verbunden ist, bereitgestellte Steuerspannung. Die am Steuereingang der Stromversorgung **(122)** anliegende Spannung bestimmt dabei, welche Leistung über die Zuleitungen **(123)** von der Sputterquelle **(102)** in das Plasma **(103)** eingekoppelt wird. Dem wesentlich langsameren Driftprozess Rechnung tragend, werden die ermittelten $G_k^{ij}$ über 20 s bis 30 s gemittelt, bevor die an die Ausgangsleitung **(114)** angelegte Steuerspannung aktualisiert wird. Zur Vermeidung von Kontaminationen des Kollimators **(104)** mit Sputter- bzw. Beschichtungsmaterial kann dieser mit einer Argon-Gasspülung **(125)** betrieben werden. Um die insgesamt bei dem Prozess anfallende Gasmenge zu reduzieren, wird vorteilhafter Weise ein Teil der für den Sputterprozess als solchen benötigten Argon-Einlass **(126)** nicht nur direkt über die Sputterquelle **(102)**, sondern neben der direkten Argonzufuhr **(124)** auch indirekt über den Kollimator **(104)** zugeführt.

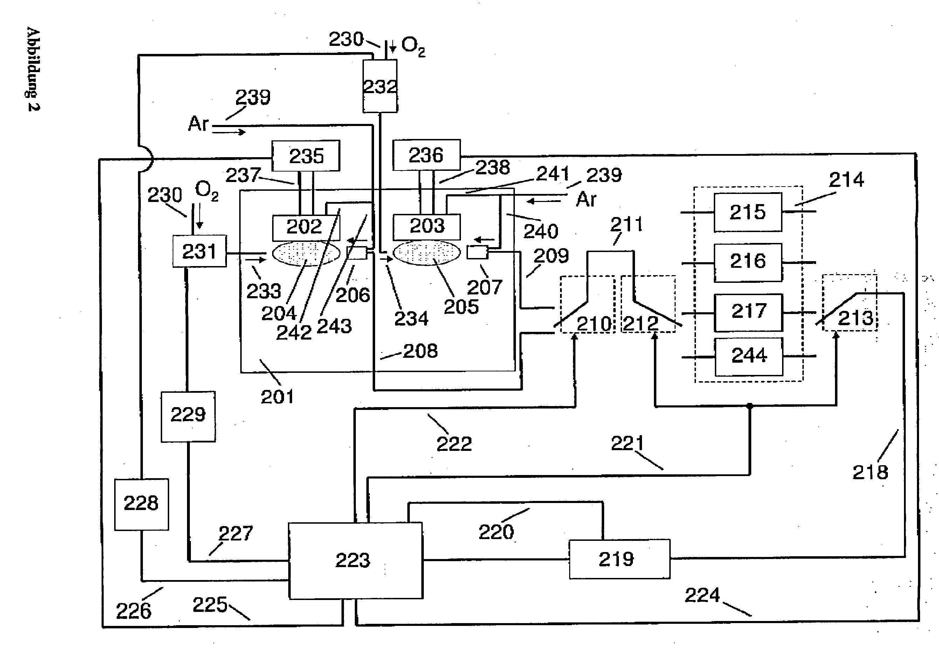

In **Abb. 2** ist ein zweites Ausführungsbeispiel für das erfindungsgemäße Verfahren bzw. die erfindungsgemäße Vorrichtung, hier für das reaktive Co-Sputtern von $TiO_2$ und $Ta_2O_5$, dargestellt. In der Prozesskammer **(201)**, welche als Vakuumkammer mit einem entsprechenden Pumpensystem ausgeführt ist, befinden sich zwei Magnetronsputterquellen **(202, 203)**. Hierbei handelt es sich um eine Magnetronquelle **(202)** mit Titan-Target bzw. eine Magnetronquelle **(203)** mit Tantal-Target. Beide Magnetronquellen **(202, 203)** sind zur groben Kompensation der Heschichtungsratedrift jeweils mit einem verfahrbaren Magnetfeldsystem ausgerüstet. Durch die Zufuhr von Trägergas **(240, 241, 242, 243)**, in diesem Fall Argon, über die Sputterquellen **(202, 203)** sowie durch die optischen Kollimatoren **(206, 207)** wird in der Prozesskammer **(201)** durch Steuerung des integrierten Vakuumsystems ein Druck erzeugt, der es ermöglicht, mit Hilfe der Stromversorgungen **(235, 236)** und deren entsprechenden Zuleitungen **(237, 238)** zu den Sputterquellen **(202, 203)** jeweils ein Plasma **(204, 205)** zu generieren, welches durch den Zerstäubungsprozess, dem Sputtern, für jede Sputterquelle **(202, 203)** separat, verschiedene Spezies generiert. Für die mit einem Titan-Target ausgerüstete Sputterquelle **(202)** sind dies neutrale, angeregte und ionisierte Argon-Atome, neutrale, angeregte und ionisierte Titan-Atome sowie bei Zugabe von Reaktivgas, in diesem Fall Sauerstoff, auch dessen neutrale, angeregte und ionisierte Atome bzw. Moleküle. Für die mit einem Tantal-Target ausgerüstete Sputterquelle **(203)** sind dies neben neutralen, angeregten und ionisierten Argon-Atomen neutrale, angeregte und ionisierte Tantal-Atome sowie bei Zugabe von Reaktivgas, in diesem Fall Sauerstoff, auch dessen neutrale, angeregte und ionisierte Atome bzw. Moleküle. Über die mit Argon gespülten Kollimatoren **(206, 207)** wird mittels Lichtwellenleiter **(208, 209)**, welche aus je einer Glasfaser oder je einem Bündel von Glasfasern bestehen können, das, von den in den Plasmen **(204, 205)** befindlichen Spezies, emittierte Licht an die Eingänge eines Eingangskanalumschalters **(210)**, in diesem Fall einem piezoelektrischen Faserschalter 2:1, geleitet. Der Ausgang des Eingangskanalumschalters **(210)** ist über einen Lichtwellenleiter **(211)** mit dem Eingang eines weiteren Eingangskanalumsehalters **(212)**, in diesem Fall einem piezoelektrischen Faserschalter 1:4, verbunden. Der μController **(223)** sendet über Steuerleitungen **(221, 222)** BCD-Binärcode und schaltet dadurch die Eingangskanaltunschalter **(210, 212)** und den Ausgangskanalumschalter **(213)**, in diesem Fall einen piezoelektrischen Faserschalter 4:1, so, dass zum einen der Eingangskanalumschalter **(212)** und der Ausgangskanalumschalter **(213)** simultan mit der Frequenz $f_M$ geschalten werden und dass stets ein Eingang des Filterblocks **(214)** mit dem Eingangskanalumschalter **(212)** und das der entsprechende Ausgang des Filterblocks **(214)** mit dem Ausgangskanalummhalter **(213)** verbunden ist sowie zum anderen der Eingangskanalumschalter **(210)** mit der Frequenz $f_M^{\bullet}$, synchronisiert zu $f_M$, zwischen den Lichtwellenleitern **(208, 209)** geschaltet wird. Hierbei ist

$$f_M^* = \frac{f_M}{z}$$ und z ist die Anzahl der Filterelemente im Filterblock **(214)**, d.h. hier 4. Je nach Schalterstellung des Eingangskanalumschalters **(210)** wird über den Lichtwellenleiter **(211)** das vom Plasma **(204, 205)** emittierte Licht der Titan-Sputterquelle **(202)** oder der Tantat-Sputterquelle **(203)** zum Eingang des Eingangskanalumschalters **(212)** geleitet. Je nach Schalterstellung des Eingangskanalumschalters **(212)** und des Ausgangskanalumschalters **(213)** muss das Licht im Filterblock **(214)** den dielektrischen Interferenzfilter für Titan **(215)**, Sauerstoff **(216)**, Argon **(217)** oder Tantal **(244)** passieren. Dabei wird nur Licht in dem für den Filter durchlässigen schmalbandigen Wellenlängenbereich hindurchgclassen. Für das hier nicht näher erläuterte Ausführungsbeispiel, dass die Sputterquellen **(202, 203)** mit dem gleichen Targetmaterial, z.B. Titan, ausgestattet sind, kann natürlich das Filterelement **(244)** entfallen. Der Ausgangskanalumschalter **(213)** leitet über den Lichtwellenleiter **(218)**, welcher aus einer Glasfaser oder einem Bündel von Glasfasern bestehen kann, das von der Filtcrbox **(214)** vermittels der verschiedenen Filterelemente **(215, 216, 217, 244)** gefilterte Licht auf den Eingang des PM **(219)**. Der PM **(219)** wandelt das eintreffende Licht in eine elektrische Spannung, welche am Ausgang des PM **(219)** zur Verfügung gestellt wird. Die Höhe der am Ausgang des PM **(219)** bereitgestellten Spannung wird neben der am Eingang des PM **(219)** eintreffenden Lichtintensität vom Verstärkungsfaktor, genauer gesagt der am Steuereingang des PM **(219)** anliegenden Verstärkerspannung, bestimmt. Diese Verstärkerspannung wird als Referenzspannung vom µController **(223)** über einen entsprechenden Ausgang am µController **(223)**, mittels einer Steuerleitung **(220)**, dem PM **(219)** über einen entsprechenden Eingang zugeführt. Die Höhe dieser Referenzspannung wird vom µController **(223)** simultan mit dem Schalten des Einbangskanalumschalters **(212)** und des Ausgangskanalumschalters **(213)** in Abhängigkeit von der Position der Umschalter **(210, 212, 213)** vorgeben. Durch die hier geschilderte Anordnung passiert das Licht auch den Filter von Titan **(215)**, obwohl der Eingangskanajumschalter **(210)** das vom Plasma **(205)** der Tantal-Sputterquelle **(203)** emittierte Licht weiterleitet bzw. das Licht passiert den Filter von Tantal **(244)**, obwohl der Eingangskanalumschalter **(210)** das vom Plasma **(204)** der Titan-Sputterquelle **(202)** emittierte Licht weiterleitet. Die dabei gewonnenen Lichtintensitätsäquivalente werden durch den µController **(223)** nicht ausgewertet.

Im anfänglichen Betrieb der Magnetron-Sputterquellen **(202, 203)** wird nach dem Zünden des jeweiligen Plasmas **(204, 205)** ohne Betrieb mit Reaktivgas (in diesem Fall Sauerstoff) für kurze Zeit (typischer Weise 3 min bis 5 min) rein metallisch gesputtert, um die Targets zu konditionieren, d.h. Verunreinigungen der Targetoberflächen zu entfernen. Nach der Konditionierung der Targetoberflächen der Sputterquellen **(202, 203)** werden in der sogenannten Kalibrierphase des Prozesses die Verstärrkerspannungen, welche durch den µController **(223)** auf den Steuereingang des PM **(219)** im späteren reaktiven Prozess gegeben werden, bestimmt. Dazu werden beim rein metallischen Sputtern in der Kalibrierphase die optischen Intensitäten in den speziellen schmalbandigen Wellenlängenbereichen für Titan über das Filterelement **(215)**, für Tantal über das Filterelement **(244)** und für Argon über das Filterelement **(217)** bestimmt wobei die anfängliche Vetstärkerspannung für Titan, Tantal und Argon beliebig sein kann. Zur Bestimmung dieser Intensitäten schaltet der µController **(223)** über Steuerleitungen **(221, 222)** durch BCD-Binärcode die Eingangskanalnmschalter **(210, 212)** und den Ausgangskanalumsehlter **(213)** so, dass das vom Kollimator **(206)** über den Lichtwellenleiter **(208)** geleitete Licht während einer Messzeit $t_M$ durch das Filterelement für Titan **(215)** gefiltert und über den Lichtwellenleiter **(218)** auf den Eingang des PM **(219)** gelegt wird. Beim Schalten des Eingangskanalumshalters **(212)** und des Ausgangskanalumschalters **(213)** wird simultan die (noch beliebige) Verstärkerspannung für den PM **(219)** durch den µController **(223)** über die entsprechenden Steuerleitungen **(220)** am entsprechenden Eingang des PM **(219)** gelegt. Die vom PM **(219)** in eine entsprechende elektrische Spannung gewandelte LichLintensität wird als analoge Spannung am Ausgang des PM **(219)** zur Verfügung gestellt. Der damit verbundene Eingang des µ Controllers **(223)** wandelt dieses Spannungssignal mittels integrierter A/D-Wandler und speichert das entstehende Ergebnis in einem ebenfalls integrierten Speicher zwischen. Anschließend wird der optische Signalweg auf Argon (für die Sputterquelle **(202)**) umgeschaltet, d.h. der µController **(223)** schaltet über die Steuerleitung **(220)** den Verstärkungsfaktor und über die Steuerleitungen **(221)** den Eingangskanalumschaleeter **(212)** und Ausgangskanalumschalter **(213)** auf das Filterelement für Argon **(217)** und wiederholt die Prozedur der Intensitätserfassung durch den µController **(223)** für Argon. Anschließend wird der optische Signalweg auf Tantal umgeschaltet, d.h. der µController **(223)** schaltet über die Steuerleitung **(220)** den Verstärkungsfaktor und über die Steuerleitungen **(221,222)** die Eingangskanalumschalter **(210, 212)** und den Ausgangskanalumschalter **(213)** auf das Filterelement für Tantal **(244)** und wiederholt die Prozedur der Intensitätserfassung durch den µCorttroller **(223)** für Tantal. Nachfolgend wird der optische Signalweg auf Argon (nun für die Sputterquelle **(203)**) umgeschaltet, d.h. der µController **(223)** schaltet über die Steuerleitung **(220)** den Verstärkungsfaktor und über die Steuerleitung **(221)** den Eingangskanalumschalter **(212)** und den Ausgangskanalumschalter **(213)** auf das Filterelement für Argon **(217)** und wiederholt die Prozedur der Intensitätserfassung durch den µController **(223)** für Argon. Die während einer Gesamtzeit von etwa 20 ms bis 30 ms einzeln gespeicherten Intensitätsäquivalentwerte werden dann jeweils für Argon (Sputterquelle **(202)**), Argon (Sputterquelle **(203)**), Titan und Tantal gemittelt. Die Werte für die Verstärkerspannungen werden durch den μController **(223)** nun so angepasst, dass die während des nächsten Messzyklus von Argon (Sputterquelle **(202)**), Argon (Sputterquelle **(203)**), Titan bzw. Tantal vom PM **(219)** generierten Spannung für Argon in etwa 5 V bzw. 9,5 V für Tantal bzw. Titan ergeben. Dieser Kalibrierprozess wird für die Dauer von typischer Weise einigen Sekunden iterativ wiederholt, bis die Änderung der in jedem Zyklus bestimmten Verstärkerspannungen zueinander weniger als 0,5 % betragen. Bei Erfüllung dieser Bedingung werden die Verstärkerspannungen von Argon (Sputterquelle **(202)**), Argon (Sputterquelle **(203)**). Titan bzw. Tantal nachfolgend nicht mehr geändert. Nach Abschluss der Kalibrierphase schließt sich die Phase der Sauerstoffkalibrierung an.

Die Sauerstoffkalibrierung erfolgt, indem auf die Ausgangsleitungen **(226, 227)** des μControllers **(223)** jeweils eine Spannung ausgegeben wird, welche im Bereich von 0 V bis 10 V liegt. Diese Spannung wird über jeweils einen DC-DC-Wandler **(228, 229)** auf einen Spannungsbereich von 0 V bis 150 V gewandelt und jeweils auf ein piezoelektrisches Regelventil **(231, 232)** als Steuerspannung gegeben. Die piezoelektrischen Regelventile **(231, 232)** dosieren den von der zentralen Sauerstoffversorgung der Anlage kommenden Sauerstoff **(230)** so, dass der Anteil der über die Sauerstoffeinlass-systeme **(233, 234)** injizierte Sauerstoff jeweils abhängig von der an den jeweiligen Eingängen der jeweiligen piezoelektrischen Regelventile **(231, 232)** angelegten elektrischen Steuerspannung ist. Beim Einlassen von Sauerstoff in den Prozess sinkt die in dem jeweiligen speziellen schmalbandigen Wellänngenbereich für Titan bzw. Tantal ermittelte Lichtintensität. Die im μController **(223)** enthaltenen PID-Regler regeln die jeweils in den Prozess eingelassene Sauerstoffmenge über die Änderung der jeweils an die Ausgangsleitungen **(226, 227)** angelegten Steuerspannungen der piezoelektrischen Regelventile **(231, 232)** so, dass eine bestimmte, jeweils aus der Erfahrung stammende, Lichtintensitätsabsenkung bei der Sputterquelle **(202)** bzw. **(203)** erreicht wird. Die aus der Erfahrung stammenden Lichtintensitätsabsenkungen, welche für den gewünschten Prozess notwendig sind, werden vor dem Prozessstart mittels externen Eingabemöglichkeiten (z.B. Touchpad oder externe Anlagen-steuerung) über die im μcontroller **(223)** integrierte UART-Schnittstelle eingegeben. Nach Stabilisierung der Sauerstoffregelung, was typischer Weise ca. 30 s bis 60 s dauert, werden die Lichtintensitäten in dem speziellen schmalbandigen Wellenlängenbereich für Sauerstoff jeweils für die Sputterquellen **(202)** bzw. **(203)** mit Hilfe der Umschaltung des optischen Signalweges, d.h. über einmaliges Schalten des Eingangskanalumschalters **(212)** und des Ausgangakanalumschalters **(213)** auf das Filterelement für Sauerstoff **(216)** und danach über fortwährendes Schalten des Eingangskanalumschalters **(210)**, mit der Frequenz $f_M$ bestimmt. Da hierbei der Eingangskanalumschalter **(212)** und der Ausgangskanalumschalter **(213)** nicht fortwährend umschalten müssen, kann der Eingangskanalumschalter **(210)** anstele mit der Fre-quenz $f_M^*$ hier mit der Frequenz $f_M$ schalten. Die ein-zelnen bestimmten Lichtintensitäten werden gespei-chert. Nach ca. 20 ms bis 30 ms wird jeweils ein Mittelwert gebildet. Die Verstäkerspannung, welche vom μControl-ler **(223)** auf den Eingang des PM **(219)** über die Steuerleitung **(220)** gegeben wird, wird in diesem Fall so ein-gestellt, dass der vom μController **(223)** gebildete Mit-telwert für die Lichtintensität eine vom PM **(219)** generierten Spannung von etwa 5 V ergibt. Dieser Sauerstoffkalibrierprozess wird iterativ wiederholt, bis die Änderung der jeweils für jede Sputterquelle **(202, 203)** in jedem Zyklus bestimmten Verstärkerspannungen zueinander weniger als 0.5 % betragen. Bei Erreichen dieser Bedingung wird die jeweilige Verstärkerspannung für Sauerstoff nicht mehr geändert. Nach Beendigung des Sauerstoffkalibrierprozesses wird die Regelung des Prozesses in den Regelmodus für ein stabiles Betriebregime geschaltet.

In dem Regelmodus des stabilen Betriebsregimes wird der optische Signalweg durch den μController **(223)** mit der Frequenz $f_M$ für die Umschalter **(212, 213)** bzw. $f_M^*$ für den Umschalter **(210)**, synchronisiert auf $f_M$, so umgeschaltet, dass über die Filterelemente **(215, 216, 217, 244)** die Intensitäten von Titan, Tantal, Sauerstoff (Sputterquelle **(202)**), Sauerstoff (Sputterquelle **(203)**), Argon (Sputterquelle **(202)**) und Argon (Sputterquelle **(203)**) bestimmt und deren Werte im μController **(223)** gespei-chert werden. Alle 20 ms bis 30 ms werden von den ermittelten Intensitäten die entsprechenden Mittelwerte ge-bildet, welche dann vom μController **(223)** mathematisch verknüpft werden. Bei der hier vorgestellten Regelung handelt es sich um eine Quotientenbildung, d.h. es werden die Größen $G_k^{ij}$ bzw. $K_{mn}^{ij}$ gebildet, wobei $G_k^{ij}$ aus den entsprechenden Intensitäten von Titan und Argon (Sputterquelle **(202)**) bzw. Tantal und Argon (Sputterquelle **(203)**) bzw. $K_{mn}^{\prime ij}$ aus den entsprechenden Intensitäten von Titan und Sauerstoff (Sputterquelle **(202)**) bzw. Tantal und Sauerstoff (Sputterquelle **(203)**) gebildet werden. Alternativ kann zum Verhältnis $G_k^{ij}$ für Tantal und Argon (Sputterquelle **(203)**) auch ein Verhältnis $K_{mn}^{ij}$ für Titan und Tantal zur Regelung genutzt werden. Analog dazu ist bei Bestimmung von $G_k^{ij}$ aus Tantal und Argon (Sputterquelle **(203)**) auch die Bestimmung von $K_{mn}^{ij}$ aus Titan und Tantal möglich. Vorteilhafter Weise wird der Wert $K_{mn}^{ij}$ so gebildet, dass Sauerstoff der Dividend vom Quotienten ist. Der μController **(223)** regelt

beide Prozesse nun so, dass sowohl $G_k^{ij}$ als auch $K_{mn}^{ij}$ konstant gehalten werden. Der zeitliche Rahmen, in welchem für $G_k^{ij}$ bzw. $K_{mn}^{ij}$ eine Regelung notwendig wird, unterscheidet sich stark. Während in **Abb. 2** $G_k^{ij}$ bzw. $K_{mn}^{ij}$ (für Titan und Tantal) Ausdruck für die Langzeitstabilität der Zerstäubungsrate für Titan und Tantal bzw. deren Verhältnis zueinander ist, ist $K_{mn}^{ij}$ Ausdruck der Verhältnisse zwischen dem Reaktivgas (Sauerstoff) und Titan bzw. Tantal, welche prozessbedingt im Subsekundenbereich schwanken können. Dies wird vom μController **(223)** berücksichtigt, als das der μController **(223)** die über seine Ausgangsleitungen **(226, 227)** bereitgestellten Steuerspannungen alle 20 ms bis 30 ms gemäß der erfolgten Auswertung aktualisiert. Für die Konstanthaltung des Faktors $G_k^{ij}$ bzw. $K_{mn}^{ij}$ (für Titan und Tantal) ändert der μController **(223)** die an den analogen Ausgangsleitungen **(224, 225),** welche mit den Steuereingüngen der Stromversorgungen **(235, 236)** verbunden sind, bereitgestellten Steuerspannungen. Die an den Steuereingängen der Stromversorgungen **(235, 236)** anliegenden Spannungen bestimmen dabei, welche Leistungen über die Zuleitungen **(237, 238)** von den Sputterquellen **(202, 203)** in die Plasmen **(204, 205)** eingekoppelt werden. Den wesentlich langsameren Driftprozessen Rechnung tragend, werden die ermittelten $G_k^{ij}$ bzw. $K_{mn}^{ij}$ (für Titan und Tantal) über 20 s bis 30 s gemittelt, bevor die an den Ausgangsleitungen **(224, 225)** angelegte Steuerspannung aktualisiert wird.

Zur Vermeidung von Kontaminationen der Kollimatoren **(206, 207)** mit Sputter- bzw. Beschichtungsmaterial können diese mit jeweils einer Argon-Gasspülung **(240, 243)** betrieben werden. Um die insgesamt bei beiden Prozessen anfallende Gasmenge zu reduzieren, wird vorteilhafter Weise jeweils ein Teil der für den jeweiligen Sputterprozess als solchen benötigten Argon-Einlass **(239)** nicht nur direkt über die Sputterquellen **(202, 203)**, sondern neben der direkten Argonzufuhr **(241, 242)** auch indirekt über die Kollimatoren **(206, 207)** zugeführt.

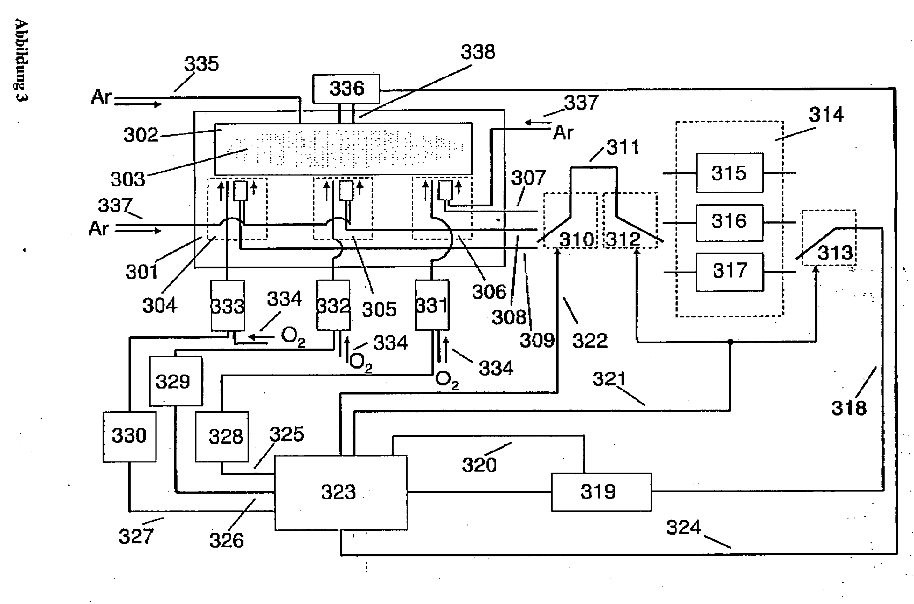

Als drittes Ausführungsbeispiel ist in **Abb. 3** als crfindungsgemäßes Verfahren bzw. als erfindungsgemäße Vorrichtung das reaktive Sputtern von $TiO_2$ mit einer langgestreckten Quelle **(302)** und integrierten drei Mess-Regel-Kanälen **(304, 305, 306)** dargestellt.

In der Prozesskammer **(301)**, welche als Vakuumkammer mit einem entsprechenden Pumpensystem ausgeführt, ist, befindet sich eine Magnetron-Sputterquelle **(302)**, welche mit einem Sputtertarget aus Titan und zur groben Kompensation der Beschichtungsratedrift mit einem verfahrbaren Magnetfeldsystem ausgerüstet ist. Durch die Zufuhr eines Trägergases **(335,337)**, in diesem Fall Argon, über die Sputterquelle **(302)** sowie durch die in den Mess-Regel-Kanälen **(304, 305, 306)** enthaltenen Kollimatoren wird in der Prozesskammer **(301)** durch Steuerung des dort integrierten Vakuumsystems ein Druck erzeugt, der es ermöglicht, mit Hilfe einer Stromversorgung **(336)** und deren Zuleitungen **(338)** zur Sputterquelle **(302)** ein Plasma **(303)** zu generieren, welches durch den Zersläubungsprozess, dem Sputtern, verschiedene Spezies, wie neutrale, angeregte und ionisierte Argon-Atome bzw. neutrale, angeregte und ionisierte Titan-Atome sowie bei Zugabe von Reaktivgas, in diesem Fall Sauerstoff, auch dessen neutrale, angeregte und ionisierte Atome bzw. Moleküle, enthält. Die in der Sputterquelle **(302)** integrierten Mess-Regel-Kanäle **(304, 305, 306)** enthalten jeweils einen Kollimator, eine an den Kollimator angeschlossene Argon-Zufuhr zum Spülen des Kollimators sowie einen zugeordneten Sauerstoffeinlass, welcher von dem jeweils angeschlossenen Regelventil **(331, 332, 333)** mit Sauerstoff **(334)** versorgt werden kann. An jeden Kollimator ist eine Glasfaser bzw. ein Bündel von Glasfasern **(307, 308, 309)** angeschlossen, um das, von den im Plasma **(303)** befindlichen Spezies, emittierte Licht an die Eingänge des Eingangskanalumschalters **(310)**, in diesem Fall einem piezoelektrischen Faserschalters 3:1, zu leiten. Der Ausgang des Eingangskanalumschalters **(310)** ist über einen Lichtwellenleiter **(311)** mit dem Eingang eines weiteren Eingangskanalumschalters **(312),** in diesem Fall einem piezoelektrischen Faserschalter 1:3, verbunden. Der μController **(323)** sendet über Steuerleitungen **(321, 322)** BCD-Binärcode und schaltet dadurch die Eingangakanalumschalter **(310, 312)** und den Ausgangskaualumschalter **(313),** in diesem Fall einen piezoelektrischen Faserschalter 3:1 so, dass zum einen der Eingangskanalumschalter **(312)** und der Ausgangskanalumschalter **(313)** simultan mit der Frequenz $f_M$ geschaltet werden und dass stets ein Eingang des Filterblocks **(314)** mit dem Eingangskanalumschalter **(312)** und das der entsprechende Ausgang des Filterblock **(314)** mit dem Ausgangskanalumschalter **(313)** verbunden ist sowie zum anderen der Eingangskanalumschalter **(310)** mit der Frequenz $f_M^*$, synchronisiert zu $f_M$, zwischen den Lichtwellenleitern **(307,308, 309)** geschaltet wird. Hierbei ist $f_M^* = \dfrac{f_M}{z}$ und z ist die Anzahl der Filterelemente im Filterblock **(314),** d.h. hier 3. Je nach Schalterstellung des Eingangskanalumschalters **(310)** wird über den Lichtwellenleiter **(311)** das vom Plasma **(303)** emittierte Licht der Sputterquelle **(302)** vom Mess-Regel-Kanal **(304)**, (305) oder **(306)** zum Eingang des Eingangskanalumschalters **(312)** geleitet. Je nach Schalterstellung des Eingangskanalumschalters **(312)** und des Ausgangskanalumschalters **(313)** muss das Licht im Filterblock **(314)** den dielektrischen Interferenzfilter für Titan **(315)**, Sauerstoff **(316)** oder Argon **(317)** passieren. Dabei wird nur Licht in dem für den Filter durchlässigen schmalbandigen Wellenlängenbereiches hindurchgelassen. Der Ausgangskanalumschalter **(313)** leitet über den Lichtwellenleiter **(318),** welcher aus einer Glasfaser oder einem Bündel von Glasfasern bestehen kann, das von der Filterbox **(314)** vermittels der verschiedenen Filterelemente **(315, 316, 317)** gefilterte Licht auf den Eingang des PM **(319).** Der PM **(319)** wandelt das eintreffende Licht in eine elektrische Spannung, welche am Ausgang des PM **(319)** zur Verfügung gestellt wird. Die Höhe der am Ausgang des PM **(319)** bereitgestellten Spannung wird neben der am Eingang des PM **(319)** eintreffenden Lichtintensität vom Verstärkungsfaktor, genauer gesagt der am Steuereingang des PM **(319)** anliegenden Verstärkerspannung, bestimmt. Diese Verstärkerspannung wird als Referenzspannung vom μController **(323),** mittels einer Steuerleitung **(320),** dem PM **(319)** über einen entsprechenden Eingang zugeführt. Die Höhe dieser Referenzspannung wird vom μController **(323)** simultan mit dem Schalten des Emgangskanalumschalters **(312)** und des Ausgangskanalumschalters **(313)** in Abhängigkeit von der Position der Umschalter **(310, 312, 313)** vorgegeben.

Im anfänglichen Betrieb der Magnetron-Sputterquelle **(302)** wird nach dem Zünden des Plasmas (303) ohne Betrieb mit Reaktivgas (in diesem Fall Sauerstoff) für kurze Zeit (typischer Weise 3 min bis 5 min) rein metallisch gesputtert, um das Target zu konditionieren, d.h. Verunrcinigungen der Targetoberfläche zu entfernen. Nach der Konditionierung der Targetoberfläche der Sputterquelle **(302)** werden in der sogenannten Kalibrierphase des Prozesses die Verstärkerspannungen, welche durch den μController **(323)** auf den Steuereingang des PM **(319)** im späteren reaktiven Prozess gegeben werden, bestimmt. Dazu werden beim rein metallischen Sputtern in der Kalibrierphase die optische Intensität in den speziellen schmalbandigen Wellenlängenbereich für Titan über das Filterelement **(315)** und für Argon über das Filterelement **(317)** bestimmt, wobei die anfängliche Verstärkerspannung für Titan und Argon beliebig sein kann. Zur Bestimmung dieser Intensitäten schaltet der μController **(323)** über Steuerleitungen **(321, 322)** durch BCD-Binärsignale die Eingangskanalumschalter **(310, 312)** und den Ausgangskanalumschalter **(313)** so, dass das von dem Mess-Regel-Kanal **(305)** über den Lichtwellenleiter **(308)** geleitete Licht während einer Messzeit $t_M$ durch das Filterelement für Titan **(315)** gefiltert und über den Lichtwellenleiter **(318)** auf dem Eingang des PM **(319)** gelegt wird. Beim Schalten des Eingangskanalumschalters **(312)** und des Ausgangskanalumschalters **(313)** wird simultan die (noch beliebige) Verstärkerspannung für den PM **(319)** durch den μController **(323)** über die entsprechenden Steuerleitungen **(320)** am entsprechenden Eingang des PM **(319)** gelegt. Die vom PM **(319)** in eine entsprechende Spannung gewandelte Lichtintensität wird als analoge Spannung am Ausgang des PM **(319)** zur Verfügung gestellt. Der damit verbundene Eingang des μControllers **(323)** wandelt dieses Spannungssignal mittels integrierter A/D-Wandler und speichert das entsprechende Ergebnis in einen ebenfalls integrierten Speicher zwischen. Anschließend wird der optische Signalweg auf Argon (für den Mess-Regel-Kanal **(305))** umgeschaltet, d.h. der μController **(323)** schaltet über die Steuerleitung **(320)** den Verstärkungsfaktor und über die Steuerleitungen **(321)** den Eingangskanalumschalter **(312)** und Ausgangskanalumschalter **(313)** auf das Filterelement für Argon **(317)** und wiederholt die Prozedur der Intensitälserfassung durch den μController **(323)** für Argon. Anschließend wird der optische Signalweg auf den Mess-Regel-Kanal **(304)** umgeschaltet, d.h. der μController **(323)** schaltet über die Steuerleitung **(320)** der Verstärkungsfaktor und über die Steuerleitung **(322)** den Eingangskanalumschalter **(310)** auf den Mess-Regel-Kanal **(304)** sowie über die Steuerleitung **(321)** den Eingangskanalumschalter **(312)** und den Ausgangskanalumschalter **(313)** auf das Filterelement für Titan **(315).** Es wird analog die Prozedur der Intensitätserfassung des Titans für den Mess-Regel-Kanal **(304)** durch den μController **(323)** durchgeführt. Auf eine Bestimmung der entsprechenden Argon-Intensität wird in diesem Fall verzichtet, so dass der optische Signalweg nach Erfassung der Intensität des Titans für den Mess-Regel-Kanal **(304)** auf den Mess-Regel-Kanal **(306)** umgeschaltet wird, d.h. der μController **(323)** schaltet über die Steuerleitung **(322)** den Eingangskanalumschalter **(310)** auf den Mess-Regel-Kanal **(306),** um ebenfalls nur die Erfassung der Titan-Intensität in analoger Weise durchzuführen. Die während der Gesamtzeit von etwa 20 ms bis 30 ms einzeln gespeicherten Intensitütsäquivalentwerte werden dann jeweils für Argon (nur Mem-Regel-Kanal (305)) und Titan für jeweils jeden einzelnen Mess-Regel-Kanal **(304, 305,306)** gemittelt. Die Werte für die Verstärkerspannung werden durch den μController **(323)** nun so angepasst, dass die während des nächsten Messzyklus von Argon (nur Mess-Regel-Kanal **(305))** und Titan für jeweils jeden Mess-Regel-Kanal **(304, 305 ,306)** vom PM **(319)** generierten Spannung für Argon in etwa 5 V bzw. 9.5 V für Titan ergeben. Dieser Kalibrierprozess wird für eine Dauer von typischer Weise einige Sekunden iterativ wiederholt, bis die Änderung der in jedem Zyklus bestimmten Verstärkerspannungen zueinander weniger als 0,5 % betragen. Bei Erfüllung dieser Bedingung werden die Verstärkerspannungen für Argon bzw. Titan nachfolgend nicht mehr geändert. Nach Abschluss der Kalibrierphase schließt sich die Phase der Sauerstoffkalibrierung an.

Die Sauersboffkalibrierung erfolgt, indem an die Ausgangsleitungen **(325, 326, 327)** des μControllers **(323)** zunächst die gleiche Spannung im Bereich von 0 V bis 10 V angelegt wird. Diese Spannung wird über jeweils einen DC-DC-Wandler **(328, 329, 330)** auf einen Spannungsbereich von 0 V bis 150 V gewandelt und jeweils auf ein piezoelektrisches Regelventil **(331, 332, 333)** als Steuerspannung gegeben. Die piezoelektrischen Regelventile **(331, 332, 333)** dosieren den Sauerstoff **(334)** so, dass der Anteil des über die Sauerstoffeinlasssysteme der Mess-Regel-Kanäle **(304, 305, 306)** injizierte Sauerstoff jeweils abhängig von der an den jeweiligen Eingängen der jeweiligen piezoelektrischen Regelventile **(331, 332, 333)** angelegten elektrischen Steuerspannung ist. Beim Einlassen von Sauerstoff in den Prozess sinkt die jeweils für jeden Mess-Regel-Kanal **(304, 305, 306)** in dem speziellen schmalbandigen Wellenlängenbereich für Titan ermittelte Lichtintensität. Die im μController (323) enthaltenen PID-Regler regeln die jeweils in den Prozess eingelassene Sauerstoffmenge über die Änderung der jeweils an die Ausgangsleitungen **(325, 326, 327)** angelegten Steuerspannungen der piezoelektrischen Regelventile **(331, 332, 333)** so, dass eine bestimmte, jeweils aus der Erfahrung stammende, Lichnntensitätsabsenkung bei den Mess-Regel-Kanälen **(304, 305, 306)** erreicht wird. Die aus der Erfahrung stammenden Lichtintensitätsabsenkungen, welche für den gewünschten Prozess notwendig sind, werden vor dem Prozess mittels externen Eingabemöglichkeiten (z.B. Touchpad oder externe Anlagensteuerung) über die in den μController **(323)** integrierte UART-Schnittstelle eingegeben. Nach Stabilisierung der Sauerstoffregelung, was typischer Weise 30 s bis 60 s dauert, werden die Lichtintensitäten in den speziellen schmalbandigen Wellenlängenbereich für Sauerstoff jeweils für die einzelnen Mess-Regel-Kanäle **(304, 305, 306)** mit Hilfe der Umschaltung des optischen Signalweges, d.h. über einmaliges Schalten des Eingangskanalumschalters **(312)** und des Ausgangskanalumschalters **(313)** auf das Filterelement für Sauerstoff **(316)** **und** danach über fortwährendes Schalten des Emgangskanalumschalters **(310),** mit der Frequenz $f_M$ bestimmt. Da hierbei der Eingangskanalumschalter **(312)** und der Ausgangskanalumschalter **(313)** nicht fortwährend umschalten muss, kann der Eingangskanalumschalter **(310)** anstelle mit der Frequenz

$f_M^*$ hier mit der Frequenz $f_M$ schalten. Die einzelnen bestimmten Lichtintensitäten werden gespeichert. Nach ca. 20 ms bis 30 ms wird jeweils ein Mittelwert gebildet. Die Verstärkerspannung, welche vom μController **(323)** auf den Eingang des PM **(319)** über die Steuerleitung **(320)** gegeben wird, wird in diesem Fall so eingestellt, dass der vom μController **(323)** gebildete Mittelwert für die Lichtintensität eine vom PM **(319)** generierten Spannung von etwa 5 V ergibt. Dieser Sauerstoffkalibrierprozess wird iterativ wiederholt, bis die Änderung der jeweils für jeden Mess-Regel-Kanal **(304, 305, 306)** in jedem Zyklus bestimmten Ventärkerspannungen zueinander weniger als 0,5 % betragen. Bei Erreichen dieser Bedingung wird die jeweilige Verstärkerspannung für Sauerstoff nicht mehr geändert. Nach Beendigung des Sauerstoffkalibrierprozesses wird die Regelung des Prozesses in den Regelmodus für ein stabiles Betriebsregime geschaltet.

In dem Regelmodus des stabilen Betriebsregimes wird der optische Signalweg durch den μController **(323)** mit der Frequenz $f_M$ für die Umschalter **(312, 313)** bzw. $f_M^*$ für den Umschalter **(310),** synchronisiert auf

$f_M$, so umgeschaltet, dass über die Filterelemente **(315,316, 317)** die Intensitäten von Titan sowie Sauerstoff für alle Mess-Regel-Kanäle **(304, 305, 306)** und Argon (nur für den Mess-Regel-Kanal **(305))** bestimmt und deren Werte im μController **(323)** gespeichert werden. Alle 20 ms bis 30 ms werden von den ermittelten Intensitäten die entsprechenden Mittelwerte gebildet, welche von dem μController **(323)** mathematisch verknüpft werden. Bei der hier vorgestellten Regelung handelt es sich um eine Quotientenbildung, d.h. es werden die Größen

$G_k^{ij}$ bzw. $K_{mn}^{ij}$ gebildet, wobei $G_k^{ij}$ aus der Intensität von Titan und Argon für den Mess-Regel-Kanal **(305)** bzw. $K_{mn}^{ij}$ aus den entsprechenden Intensitäten von Titan und Sauerstoff für alle Mess-Regel-Kanäle **(304, 305, 306)** gebildet werden. Vorteilhafterweise wird der Wert $K_{mn}^{ij}$ so gebildet, dass die Sauerstoffintensität der Dividend des jeweiligen Quotienten ist. Der μController **(323)** regelt den Prozess nun so, dass sowohl $G_k^{ij}$ als auch $K_{mn}^{ij}$ konstant gehalten werden. Der zeitliche Rahmen, in welchem für $G_k^{ij}$ bzw. $K_{mn}^{ij}$ eine Regelung notwendig wird, unterscheidet sich stark. Während in **Abb. 3** $G_k^{ij}$ Ausdruck für die Langzeitstabilität der Zerstäubungsrate für Ti ist und damit im Wesentlichen langsamen Driftprozessen unterworfen ist, ist $K_{mn}^{ij}$ Ausdruck der Verhältnisse zwischen dem Reaktivgas (Sauerstoff) und Titan, welche prozessbedingt im Subsekundenbereich schwanken können. Dies wird von dem μController **(323)** berücksichtigt, als dass der μController **(323)** die über seine Ausgangsleitungen **(325, 326, 327)** bereitgestellten Steuerspannungen alle 20 ms bis 30 ms gemäß der erfolgten Auswertung aktualisiert. Für die Konstanthaltung des Fäktors $G_k^{ij}$ ändert der μController **(323)** die an der analogen Ausgangsleitung **(324)**, welche mit dem Steuereingang der Stromversorgung **(336)** verbunden ist, bereitgestellte Steuerspannung. Die an dem Steuereingang der Stromversorgung (336) anliegende Spannung bestimmt dabei, welche Leistung über die Zuleitungen **(338)** von der Sputterquelle **(302)** in das Plasma **(303)** eingekoppelt wird. Den wesentlich langsameren Driftprozess Rechnung tragend, werden die ermittelten $G_k^{ij}$ über 20 s bis 30 s gemittelt, bevor die an der Ausgangsleitung **(324)** angelegte Steuerspannung aktualisiert wird.

Zur Vermeidung von Kontaminationen der in den Mess-Regel-Kanälen **(304, 305, 06)** integrierten Kollimatoren mit Sputter- bzw. Beschichtungsmaterial können diese mit jeweils einer ebenfalls in den einzelnen Mess-Regel-Kanälen **(304, 305, 306)** integrierten Argonspülung **(337)** betrieben werden. Um die insgesamt bei dem Prozess anfallende Gasmenge zu reduzieren, wird vorteilhafter Weise jeweils ein Teil der für den Sputterprozess als solchen benötigten Argoneinlass nicht nur direkt, über die Sputterquelle **(302)**, sondern neben der direkten Argonzufuhr **(335)** auch indirekt über die in den Mess-Regel-Kanälen **(304, 305, 306)** integrierten Kollimatoren zugeführt.

**Patentansprüche**

1. Vorrichtung zur Auswertung des von einem Plasma emittierten Lichtes zur Regelung von plasmagestützten Vakuumprozessen, **dadurch gekennzeichnet dass** die Vorrichtung aus mindestens einem optischen Empfänger, mindestens einem Eingangskanalumschalter, einem Filterblock, mindestens einem Ausgangskanalumschalter, einem Photomultiplier, einem μController, mindestens einem Signal-Wandlerbaustein und mindestens einem Gas-Stellglied besteht.

2. Vorrichtung nach Anspruch 1, **dadurch gekennzeichnet, dass** dem Eingangskanalumschalter zusätzlich ein weiterer Eingangskanalumschalter vorgeschaltet ist.

3. Vorrichtung nach einem der vorhergehenden Ansprüchen, **dadurch gekennzeichnet, dass** der vorgeschaltete Eingangskanalumschalter, der Eingangskanalumschalter und der Ausgangskanalumschalter jeweils ein optischer Multiplexer, vorzugsweise jeweils ein piezoelektrischer Faserschalter, ist.

4. Vorrichtung nach einem der vorhergehenden Ansprüche, **dadurch gekennzeichnet, dass** der Filterblock aus einzelnen, parallel zueinander angeordneten, optischen Filterelementen, vorzugsweise dielektrischen Interferenzfiltern, besteht.

5. Vorrichtung nach einem der vorhergehenden Ansprüche, **dadurch gekennzeichnet, dass** das Gas-Stellglied ein piezoelektrisches Regelventil, ein Mass-Flow-Controller oder eine Kombination aus einem Liqui-Flow-Controller und einem Verdampfer ist.

6. Vorrichtung nach einem der vorhergehenden Ansprüche, **dadurch gekennzeichnet, dass** zur Auswertung und zur Regelung ein progammierbarer Controller benutzt wird, der Speicher zum Zwischenspeichern von numerischen Werten, mindestens eine UART-Schnittstelle, mindestens einen analogen Spannungseingang mit A/D-Wandie, mindestens einen PID-Regler, mindestens zwei D/A-Wandler mit zugeordneten analogen Spannungsausgängen, mindestens zwei digitale Ausgänge und mindestens einen interruptfähigen digitalen Eingang aufweist.

7. Verfahren zur Auswertung des von einem Plasma emittierten Lichtes zur Regelung von plasmagestützten Vakuumprozessen, **dadurch gekennzeichnet, dass** das von einem optischen Empfänger empfangene Licht durch einen Eingangskanalumschalter sequentiell auf die Eingänge von optischen Filterelementen in einer Filterbox und durch einen Ausgangskanalumschalter ebenfalls sequentiell und synchron zum Eingangskanalumschalter von den, den Eingängen der in der Filterbox befindlichen optischen Filterelementen, zugeordneten Ausgängen der Filterbox auf einen Liehtwellenleiter geleitet wird.

8. Verfahren nach Anspruch 7, **dadurch gekennzeichnet, dass** das vom Plasma emittierte Licht in verschiedenen schmalbandigen Wellenlängenbereichen detektiert wird.

9. Verfahren nach den Ansprüchen 7 oder 8 **dadurch gekennzeichnet, dass** das vom Ausgangskanalumschalter kommende Licht auf den Eingang eines Photomultipliers geleitet und durch diesen in eine der Lichtintensität entsprechende elektrische Spannung gewandelt wird.

10. Verfahren nach einem der Ansprüche 7 bis 9, **dadurch gekennzeichnet, dass** in einem programmierbaren μController die Auswertung der sequentiell erfassten Lichtintensitätsäquivalente durch Mittelwertsbildung derselben Lichtintensitätsäquivalente und Quotientenbildung von verschiedenen Mittelwerten erfolgt.

11. Verfahren nach einem der Ansprüche 7 bis 10, **dadurch gekennzeichnet, dass** die Steuergrößen elektrische Spannungen und proportional den Auswertergebnissen sind.

12. Verfahren nach einem der Ansprüche 7 bis 11, **dadurch gekennzeichnet, dass** der μController über die digitalen Ausgänge das Schalten der Ein- bzw. Ausgangskanalumschalter veranlasst, wobei der vorgeschaltete Eingangskanalumschalter mit der Frequenz $f_M^{\bullet}$ und der Eingangs- bzw. Ausgangskanalumschalter simultan mit der Frequenz $f_M$ betrieben werden und das Schalten auf die Frequenz $f_M$ synchronisiert ist.

**Abbildung 1**

Abbildung 2

Abbildung 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DD 239810 A1
- US 6818561 B1
- US 6815362 B1
- US 020040045934 A1
- DE 10341513 A1

- DE 10208044 B4
- US 6603538 B1
- US 5877032 A
- DE 102008017412 A1